(19) Europäisches Patentamt European Patent Office Office européen des brevets

(11) **EP 1 420 949 B1**

(12) **EUROPEAN PATENT SPECIFICATION**

(45) Date of publication and mention
of the grant of the patent:
**04.04.2012 Bulletin 2012/14**

(21) Application number: **02763568.9**

(22) Date of filing: **29.08.2002**

(51) Int Cl.:
*B32B 27/00* (2006.01)    *B32B 15/08* (2006.01)
*H05K 1/03* (2006.01)

(86) International application number:
**PCT/US2002/027545**

(87) International publication number:
**WO 2003/020511 (13.03.2003 Gazette 2003/11)**

(54) **SOLID SHEET MATERIAL ESPECIALLY USEFUL FOR CIRCUIT BOARDS**

FESTER SCHICHTSTOFFMATERIAL BESONDERS VERWENDBAR FÜR LEITERPLATTEN

MATERIAU EN FEUILLE SOLIDE UTILE NOTAMMENT POUR LES CARTES DE CIRCUITS

(84) Designated Contracting States:
**DE FR GB IT NL**

(30) Priority: **30.08.2001 US 315890 P**

(43) Date of publication of application:
**26.05.2004 Bulletin 2004/22**

(73) Proprietor: **E.I. DU PONT DE NEMOURS AND COMPANY**
**Wilmington, DE 19898 (US)**

(72) Inventors:
• **SAMUELS, Michael, R.**
**Wilmington, DE 19808 (US)**
• **KAHN, Subhotosh**
**Midlothian, VA 23114 (US)**

• **LEVIT, R. Mikhail**
**Richmond, VA 23229 (US)**

(74) Representative: **Morf, Jan Stefan et al**
**Abitz & Partner**
**Patentanwälte**
**Postfach 86 01 09**
**81628 München (DE)**

(56) References cited:
**EP-A- 0 167 682    EP-A- 0 320 901**
**EP-A- 0 510 927    EP-A- 0 768 334**
**EP-A- 0 930 393    EP-A- 0 990 512**
**WO-A-97/06204     FR-A- 2 376 501**
**FR-A- 2 507 123    US-A- 5 194 484**
**US-A- 5 393 601**

**Description**

FIELD OF INVENTION

The field of invention relates to solid sheets comprising thermoplastic polymer having low moisture absorption and high tensile modulus fibers, in which the thermoplastic polymer is the matrix polymer, substrates for circuit boards made therefrom, and methods of making the foregoing.

BACKGROUND

Circuit boards are important items of commerce, being used in virtually every electronic device. The "board" or supporting member of a circuit board or other electronic devices (such as the interposer in a flip-chip package) is an important component of such devices, and properties of the materials used to make such boards are important to the functioning of the electronic or electrical circuit.

As electronic components have become more sophisticated, the demands placed upon the materials used for boards have increased. For example, for many applications it is preferred that the board have a coefficient of expansion which matches those of the chips mounted on the board, and/or that the board have a low dielectric constant, and low dissipation factor, especially when high frequency devices are mounted on the board. These three factors are often adversely affected by the absorption of moisture by the board materials, which changes the dimensions of the board and/or changes the dielectric constant and/or dissipation factor of the board itself, and/or causes warpage.

The simplest boards for relatively nondemanding applications are typically made from a thermoset resin such as an epoxy filled with a fibrous reinforcement such as glass fiber. The glass fiber, often in the form of a woven fabric, is saturated with liquid epoxy resin to form a "prepreg", which is cured in form of a board. As the demands on boards increase, the glass may be replaced by a higher modulus infusible fiber such as an aramid. However, fibers such as aramid fibers, and epoxy resins, absorb significant amounts of moisture, and so are sometimes unsuitable for use together in highly demanding circuit board uses. Thus there is a need for improved circuit board materials.

Japanese Patent Application 2000-334871 describes the preparation of a sheet from which a prepreg may be formed by "laminating" a three layer structure in which the middle layer may be an nonwoven sheet containing synthetic organic fiber and the two outer layers may contain aramids or other infusible fibers. From the way prepreg formation is described, it appears the sheet is porous.

Japanese Patent Application 11-117184 describes the preparation of a sheet from which a prepreg may be formed by forming a nonwoven sheet from aramid and liquid crystalline polymer (LCP) fibers, heating sheet under pressure to make the LCP flow, and then adding a thermoset resin to form a prepreg. From the reported densities of the sheets actually made, they are porous.

Japanese Patent Application 9-21089 describes the preparation of an LCP nonwoven sheet (paper) which is reported to have low moisture absorption. Other fibers can also be present in the sheet. The product, after being heated under pressure to partially consolidate the sheet, is apparently still a paper-like material.

Japanese Patent Application 11-229290 describes the preparation of a paper made from LCP and aramid fibers which can be impregnated with an epoxy resin which is then cured. The resulting board may be used as a circuit board. No melting or flow under heat and/or pressure of the LCP is described.

SUMMARY OF INVENTION

Our invention includes:

sheets, comprising(a) a nonwoven sheet of short high tensile modulus fibers, and (b) a thermoplastic polymer having low moisture absorption; the sheet having an apparent density which is at least 75% of its calculated density.
laminates made therefrom;
circuit boards made therefrom;
processes for the production of a solid sheet material, comprising heating and applying pressure to, for a sufficient amount of time,:

(a) a multilayer sheet structure, comprising, at least one layer containing a nonwoven sheet of high tensile modulus fiber and at least one other layer, and at least one of said layers present comprises a thermoplastic polymer having low moisture absorption; or
(b) a single layer sheet structure comprising a nonwoven fabric comprising short lengths of a high tensile modulus fiber and a thermoplastic polymer having low moisture absorption;

to form a sheet having an apparent density of at least 75% of its calculated density.

## DETAILED DESCRIPTION OF PREFERRED EMBODIMENTS

Herein certain terms are used. Some of these are defined below.

By a "thermoplastic polymer having low moisture absorption" (TP) is meant a thermoplastic plastic polymer which absorbs less than 1.0 weight percent moisture (based on the weight of the thermoplastic polymer) when measured on a sheet of pure thermoplastic polymer by the method described below. Preferably the moisture absorption of the thermoplastic polymer is 0.5 weight percent or less, more preferably 0.25 weight percent or less and especially preferably 0.10 weight percent or less.

By "high tensile modulus fibers" (HTMF) are meant these product forms having a tensile modulus of 10 GPa or more, preferably 50 GPa or more, more preferably 70 GPa or more, when measured in accordance with ASTM D885-85 method, using a 1.1 twist multiplier. HTMF herein include high tensile modulus fibers, fibrils and fibrids, unless it is specifically indicated not all three are included. The HTMFs are synthetic organic materials, and this does not include carbon fibers of any kind.

By "LCP" is meant a polymer which is anisotropic when tested by the TOT test as described in U.S. Patent No. 4,118,372 . By thermotropic is meant the LCP may be melted and is anisotropic in the melt, as described in the TOT test.

By "nonwoven HTMF containing or comprising sheet" or "nonwoven HTMF containing or comprising "fabric" or "nonwoven HTMF containing or comprising paper" is meant a nonwoven sheet (or fabric or paper) that contains (or comprises short HTMFs. In this context herein the words "paper", "sheet" and "fabric" are used interchangeably.

By "nonwoven sheet" herein is meant a nonwoven "fabric" formed by any number of different methods, for example wet lay of short fibers (often called a paper), dry lay, flash spun, melt spun, mechanically needled felt, spunlaced. A preferred form of nonwoven sheet is a paper as described in U.S. Patent Nos. 4,886,578 and 3,756,908 . These patents describe aramid papers, but other HTMFs may also be similarly used. This process also includes the optional use of a binder, wherein such binders include, but are not limited to, aramid fibrids and other binders known within the industry. Dry-lay methods of manufacturing which are well known within the art are described by U.S. Patent No. 3, 620, 903.

By "fiber" is meant an object having a length and a maximum cross-sectional dimension, the maximum cross sectional dimension typically being in the range of 0.3 $\mu$m to 100$\mu$m and an aspect ratio (length/width) of $\geq$50.

By "aramid fiber" herein is meant aromatic polyamide fiber, wherein at least 85% of the amide (-CONH-) linkages are attached directly to two aromatic rings. Optionally, additives can be used with the aramid and dispersed throughout the polyfiber structure, and it has been found that up to as much as 10 percent by weight of other polymeric material can be blended with the aramid. It has also been found that copolymers can be used having as much as 10 percent of other diamines substituted for the diamine of the aramid or as much as 10 percent of other diacid chlorides substituted for the diacid chloride of the aramid.

By "fibrils" herein is meant a fiber-like material having a diameter of 0.1 $\mu$m to 25 $\mu$m, and an aspect ratio of 3 to 100.

By "fibrids" herein is meant very small, nongranular, fibrous or film-like particles with at least one of their three dimensions to be of minor magnitude relative to the largest dimension. These particles are prepared by precipitation of a solution of polymeric material using a non-solvent under high shear.

The term "aramid fibrids", as used herein, means non-granular film-like particles of aromatic polyamide having a melting point or decomposition point above 320°C. The aramid fibrids typically have an average length in the range of 0.2 mm to 1 mm with an aspect ratio of 5 to 10. The thickness dimension is on the order of a fraction of a micrometer, for example 0.1 $\mu$m to 1.0 $\mu$m. In addition to aromatic polyamide, aramid fibrids may optionally additionally comprise one or more of dyes, pigments or other additives such as those described in U.S. Patent Nos. 5,965,072 and 5,998,309

By "short fibers" or "short lengths" of fibers herein is meant fibers with an aspect ratio of less than 2000, preferably 200-1000 and more preferably 250-600.

By "powder" herein is meant a material having an aspect ratio of less than 3. These particles typically have a maximum dimension of 5 $\mu$m to 1000 $\mu$m. Powder particles may have smooth or rough textured surfaces and may comprise fibrils attached to a "central core" section.

By "apparent density" is meant the overall volume of a piece of a sheet calculated as follows. Measuring thickness (if somewhat uneven, an average value should be determined), length and width, and multiplying these values to obtain a volume. The sheet is weighed in air. This weight is then divided by the volume to obtain an apparent density. A sheet which is porous will have an apparent density lower than its calculated density.

By "calculated density" is meant the density of an object, assuming it has no voids or pores, which is calculated from the amounts and densities of the individual materials in that object. For example, if an object was 60 weight percent of a material having a density of 1.4, and 40 weight percent of a material having a density of 1.6, the calculated density of that object would be:

$$d = 1.0/[(0.6/1.4)+(0.4/1.6)] = 1.47$$

Calculations of this type are well known in the art.

By "solid" herein is meant that the material has an apparent density which is at least about 75% of its calculated density.

By "a" or "an" herein, such as a TP or HTMF is meant one or more.

By "comprising" herein is meant the named items (materials), and any other additional materials or compositions may be present.

Preferred "solid" or "consolidated" sheets are now described.

A solid sheet is preferably formed from a multilayer (two or more layers) or a single layer structure.

A preferred single layer structure comprises nonwoven HTMF sheet or fabric which contains a TP. The TP may be present in a number of ways. It may simply be a powder which is interspersed between the fibers of the aramid nonwoven sheet. The HTMF nonwoven sheet may contain TP (especially LCP) fibers (in other words the sheet is a mixture of TP fibers and HTMF fibers). The HTMF sheet may contain TP (especially LCP) pulps or mixtures of various forms of TP such as powders, fibers and/or pulps. Preferably the TP and the HTMF are both not an LCP, that is a lower melting LCP for the TP and a higher melting LCP for the HTMF. "Fiber-shaped" LCPs may be formed simply by wet pulping of pieces of LCPs such as pellets. For example the pellets are mixed with water, and if desired one or more surfactants, and the mixture subjected to relatively high shear mixing. If the shear applied is high enough the pellets will be broken up into LCP fiber-like particles.

If the solid sheet is formed from a multilayer structure, at least one of the layers must include a nonwoven HTMF sheet or fabric, and at least one of the layers must contain a TP (an "TP layer"). For example, if two layers are present, one could be an HTMF nonwoven sheet and the other could be either a nonwoven sheet of TP or a TP film. The HTMF nonwoven sheet could also contain TP, and/or vice versa. There may be more than one layer of a nonwoven HTMF sheet or fabric, and/or TP layer present.

Typically a TP layer will be 20 to 95 percent by weight, preferably 30 to 95 percent by weight, more preferably 40 to 95 percent by weight, and especially preferably 70 to 90 percent by weight, of the total weight of HTMF and TP in a multilayer structure. For example aramid papers typically weigh 15 to 200 g/m$^2$.

In a TP layer, the TP may be present as a film, paper, short fiber, fiber, fibrid, fibril, or powder, or any combination of these. For example, because of the tendency of solid LCPs to fibrilate when worked mechanically, combinations of the above forms when the LCP is in particulate form may be employed. TPs which are particulates and do not match any of the above particulate definitions may also be used.

The amount of TP present in the single or multilayer structure must be sufficient to form a solid sheet product. Preferably, the TP will fill in essentially all the voids between HTMFs of the HTMF nonwoven sheet, as well as any voids between other materials which may be present, such as fillers. Since nonwoven HTMF sheets or fabrics, especially papers, typically have 10 to 70 percent by volume void space, the single or multilayer structure to be consolidated into a solid sheet will typically have at least 20 percent by volume TP present, more typically 30 to 95 percent by volume present. The percent voids in a TP nonwoven sheet can be readily calculated by measuring its apparent density, and using the TP's measured (solid) density. These calculation methods are well known.

Other materials may also be present in the single or multilayers, such as fillers, antioxidants, pigments, and/or other polymers, as long as the final sheet is solid.

Conditions (assuming the single or multilayer structure has enough TP present) for forming the first solid sheet are a combination of temperature (heating), pressure and the amount of time heating and pressure are applied. Generally, the higher the temperature applied, the less the pressure needed and/or the less time needed. The higher the pressure, the lower the temperature needed and/or less time is needed. The longer the time used, the lower the temperature and/or the lower the pressure which may be needed. However, in most cases it may be necessary to heat the TP to a temperature at least near its melting point. If too low a temperature, or too low a pressure, or too short a time, or any combination of these, is used, the TP may not flow enough to form a solid sheet. In this case, the temperature and/or pressure should be raised and/or the time increased. It is believed that the most important variable is temperature, particularly when approaching the melting point of the TP. Typically during the flowing of the TP (at high temperature and/or pressure) the HTMF is at least coated by, and in most instances, encapsulated by the TP. Although some of the "fibers" of the HTMF in the HTMF nonwoven sheet may be moved relative to one another, in the densified single or multilayer sheet the HTMF nonwoven sheet structure is still present.

While applying heat and pressure to form the first solid sheet, full or partial vacuum may also be applied to the single or multilayer structure to remove air or other gases dissolved in the materials of the single or multilayer structure or physically present in the structure, as between the HTMF and TP particulates. For example the single or multilayer structure may be placed in a vacuum bag or vacuum chamber and then heat and pressure applied. Using vacuum helps remove gases from the structure and avoid trapping gas bubbles (voids) in the first solid sheet. With any of the process variations described herein to consolidate the single or multilayer structure, use of vacuum is a preferred option.

A variety of methods can be used to apply both higher temperatures and pressures. A simple apparatus is a vacuum bag to which heat and pressure may be applied. A press or autoclave may also be used. A particularly preferred method is hot roll or hot belt calendering. Temperatures, pressures, and time of treatment (contact) with the hot roll(s) or belt(s) can be controlled fairly well, as can the final thickness of the first sheet. Calendering is a well known art, see for instance U.S. Patent No. 3,756,908 . To help ensure "complete" consolidation the calendering can be done in a vacuum.

The consolidation (applying heat and pressure) into a solid sheet may be carried out in one or more steps. For example, more than one pair of calender rolls may be used to gradually consolidate the sheet to a solid structure. Each step may also be done individually, for example the sheet partially consolidated, and then consolidated in a second separate step.

Metal layers on one or both sides of the sheet may be applied in a single step process, or at any step of a multistep process. For example, the sheet may be partially consolidated by a pair of calender rolls or a press belt, metal sheets applied to one or both surfaces of the sheet, and the consolidation finished in a second pair of calender rolls or another press belt.

It is preferred that the resulting sheet is "balanced" in the X-Y axes (sometimes referred to as the machine and transverse directions) in the plane of the sheet. By balanced properties is meant that the tensile modulus and/or coefficient of thermal expansion (CTE) in one direction (machine or transverse) is no more than twice than, more preferably no more than 20%, and especially preferably no more than 10%, the tensile modulus and/or CTE in the perpendicular direction. This is especially preferred when the TP comprises an LCP, and very preferred when the TP is an LCP (only). Sheeting formed by melt extrusion of TPs containing short random lengths of HTMFs (but no in nonwoven sheet form) tends to have larger differences in tensile moduli and CTEs between the machine and transverse directions, especially if the TP is LCP. This is disadvantageous for use in circuit and other electronic board applications.

Any TP which has a low moisture absorption, such as perfluorothermoplastics [for example, polytetrafluoroethylene; copolymers of tetrafluoroethylene with hexafluoropropylene, perfluoro(vinyl ethers) such as perfluoro(methyl vinyl ether)], or ethylene; poly(ether-ether-ketones); poly(ether-ketone-ketones); and poly(ether-ketones); polyesters such as poly(ethylene terephthalate, poly(ethylene 2,6-napthalate, and polyesters from bisphenol A and isophthalic/terephthalic acids; polycarbonates especially those having higher temperature glass transition temperatures; poly 4-methylpentene; poly(aryl sulfides); poly(ether-imides); poly(aryl ethers); and LCPs are useful. Preferred TPs are perfluoropolymers, particularly those mentioned above, and LCPs are especially preferred. Among the preferred properties for the TPs are very low moisture absorption, high melting point, low dielectric constant and low dielectric loss coefficient. LCPs have an excellent combination of such properties.

Useful LCPs include those which are described in U.S. Patent Nos. 3,991,013, 3,991,014 4,011,199, 4,048,148, 4,075,262, 4,083,829, 4,118,372, 4,122,070, 4,130,545, 4,153,779, 4,159,365, 4,161,470, 4,169,933, 4,184,996, 4,189,549, 4,219,461, 4,232,143, 4,232,144, 4,245,082, 4,256,624, 4,269,965, 4,272,625, 4,370,466, 4,383,105, 4,447,592, 4,522,974, 4,617,369, 4,664,972, 4,684,712, 4,727,129, 4,727,131, 4,728,714, 4,749,769, 4,762,907, 4,778,927, 4,816,555, 4,849,499, 4,851,496, 4,851,497, 4,857,626, 4,864,013, 4,868,278, 4,882,410, 4,923,947, 4,999,416, 5,015,721, 5,015,722, 5,025,082, 5,086,158, 5,102,935, 5,110,896, 5,143,956, and 5,710,237 , and European Patent Application 356,226. Preferably the TP such as an LCP has a melting point of 180°C or more, very preferably 250°C or more, more preferably 300°C or more, and especially preferably 325°C or more. Melting points are determined by ASTM D3418-82, at a heating rate of 20°C/min. The peak of the melting endotherm is taken as the melting point. These higher melting TPs will allow the circuit board to undergo high temperature processing with less possibility of warping, for example in reflow soldering. Low warpage is an important attribute of the boards used in circuit boards. LCPs are also particularly useful in this application since they have very low moisture absorption and also the permeability of LCPs to moisture is very low. Another preferred form of LCP is an aromatic polyester or aromatic poly(ester-amide), especially an aromatic polyester. By an "aromatic" polymer is meant that all of the atoms in the main chain are part of an aromatic ring, or are functional groups connecting those rings such as ester, amide, or ether (the latter of which may have been part of a monomer used). The aromatic rings may be substituted with other groups such as alkyl groups. Some particularly preferred aromatic polyester LCPs are those found in U.S. Patent Nos. 5,110,896 and 5,710,237. More than one LCP composition may be present in the first sheet, but one is preferred.

Useful HTMFs include as aramids, poly(phenylenebenzobisoxazole), poly(phenylenbenzobisimidazole), poly (phenylenebenzobisthiazole), poly(phenylene sulfide), LCPs, and polyimide. When calculating the concentration of such fibers, the total of these types of fibers present will be used, for example the total of aramid and poly(phenylenebenzobisoxazole) fiber present. Among the preferred properties are high modulus, high melting point and/or glass transition temperature and low moisture absorption.

Aramids are preferred HTMFs. Useful aramids include poly(p-phenylene terephthalamide), poly(m-phenylene isophthalamide), and poly(p-phenylene/4,4'-oxydianiline terephthalamide). Preferred aramids are poly(p-phenylene terephthalamide), poly(m-phenylene isophthalamide), and poly(p-phenylene terephthalamide) is especially preferred. A description of the formation of aramid (short) fibers, fibrids and fibrils of various types is found in U.S. Patent Nos. 5,202,184, 4,698,267, 4, 729, 921, 3, 767, 756 and 3, 869, 430. Description of the formation of nonwoven aramid sheets, especially papers, is found in U.S. Patent Nos. 5,223,094 and 5, 314, 742 . More than one aramid may be present in the first sheet.

The apparent density of the solid sheet is preferably at least 75% of its calculated density, more preferably at least 80% of its calculated density, even more preferably at least 90% of its calculated density, even more preferably at least 95% of its calculated density, and even more preferably at least 98% of its calculated density.

When applying heat and pressure to form the solid sheet(s), metal layers, such as copper (or other metal) foil may be placed on the outer surface(s) (one or both) of the single or multilayer structure(s) to be consolidated so that a metal clad laminate is produced. Often the metal layers are photolithographically etched to create circuit lines. Combinations of different single or multilayer structures may also be consolidated together with or without metal layers.

The solid sheets, usually with metal layer(s) present may be used as the supporting "board" for circuit boards. Such boards may be formed by techniques known in the art, see for instance M. W. Jawitz, "Printed Circuit Board Materials Handbook, McGraw-Hill Book Co., New York (1997). For example it is known how to coat LCPs (aside from consolidation with heat and pressure as described above) with metals (other than by using metal foils), see for instance U.S. Patent No. 5,209,819 , European Patent Application 214,827, World Patent Application 9939021, and K. Feldmann, et al., Metalloberflaeche, vol. 51, p. 349-352 (1997).

Alternatively, solid sheets without metal layers may first be formed and metal layers attached to one solid sheet or more than one solid sheet which have been plied up. Then metal layers may be attached to the outer surface(s). The assembly with metal sheets may be bonded together using heat and/or pressure, or adhesives may be used.

If metal layers are present in and/or on the solid sheet, to measure the apparent density the metal layer can first be removed (as by acid etching) before measuring the apparent density, or the metal layers may remain and their presence be taken into account by calculation, using their thickness and (known) density, when determining the apparent density of the solid sheet(s) present. If more than one layer of solid sheet is present [for example separated by metal layer(s)], then the average apparent density (overall apparent density) of the solid sheet(s) present will be used as the benchmark for apparent density.

Circuit boards (including printed wiring boards and printed circuit boards) produced from the above materials usually have low moisture absorption, and/or good high temperature resistance, and/or relatively low coefficients of thermal expansion, and/or low dielectric constant, and/or low warpage, an excellent combination of properties for a circuit board. Once the substrate boards are formed they may be processed by normal methods to make circuit boards.

"Densified" sheets containing one or more layers may also be used in or as chip package substrates, chip carriers and chip package interposers.

Procedure for Determining Equilibrium Moisture Absorption at 85°C and 85% relative humidity:

Five specimens (5 x 5 cm) of the same sample dried to a constant weight at 105°C are placed into a humidity chamber set at 85°C and 85% relative humidity. After that, weight gain of the specimens is measured at each day. When an average weight gain for 3 consecutive days is less than 1 % of the total weight gain, specimens are deemed to be at equilibrium and average moisture absorption (equal to the total weight gain) is calculated by dividing the total weight gain by the original weight of the sample and multiplying the result by 100.

EXAMPLES

The following Examples illustrate preferred embodiments of our invention. Our invention is not limited to these Examples.

In the Examples, except as noted, all of the LCP used had the composition as that of Example 4 of U.S. Patent No. 5,110,896 derived from hydroquinone/4,4'-biphenol/terephthalic acid/2,6-naphthalenedicarboxylic acid/4-hydroxybenzoic acid in molar ratio 50/50/70/30/320.

Also in the Examples herein the poly(m-phenylene isophthalamide) (PMIT) fibrids were made as described in U.S. Patent No. 3,756,908.

The poly(p-phenylene terephthalamide) (PPTA) had a linear density of about 0.16 tex and a length of about 0.67 cm (sold by E.I. du Pont de Nemours and Company under trademark KEVLAR® 49).

Poly(ethylene terephthalate) (PET) fiber used: 2.1 dpf, 6 mm long, sold as Merge 106A75 by E. I. DuPont de Nemours & Co., Inc, Wilmington DE, U.S.A.

Glass fiber used: E-type glass fiber 6.5 μm diameter and 6.4 mm long produced by Johns Manville Co., Denver, CO 80217, USA, sold as type M189.

Poly(phenylene oxide) (PPE) resin used was type 63D from the General Electric Co., Pittsfield, MA, U.S.A.

Polybenzoxazole fiber used: 1.5 dpf produced by Toyobo Co., Ltd. (FCita-ku, Osaka 530-8230, Japan) under trademark Zylon® (cut to length of 6.4 mm).

Example 1

The LCP used had the composition of the LCP of Example 9 of U.S. Patent 5,110,896, derived from hydroquinone/4,4'-biphenol/terephthalic acid/2,6-naphthalenedicarboxylic acid/4-hydroxybenzoic acid in molar ratio 50/50/85/15/320. The particulate LCP was prepared by grinding a melt blend mixture containing LCP (70 wt. %) and a polytetrafluoroethylene powder (30 wt. %) in a Bantam® Micro Pulverizer (model CF) along with liquid nitrogen until the particles passed through about a 10 mesh screen. The particles were reground in the same unit with additional liquid nitrogen until they passed through a 40 mesh screen.

Two (2.00) g of para-aramid fiber was placed in a standard laboratory pulp disintegrator(described in TAPPI Test Method T205 sp-95)together with 2500 g of water and agitated for 3 min. Independently, 69.13 g of an aqueous, never-dried, meta-aramid fibrid slurry (0.43% consistency and freeness 330 ml of Shopper-Riegler) was placed in a same type of laboratory mixer together with 2.25 g of the above described particulate LCP and about 2000 g of water and agitated for 1 min. Both dispersions were poured together into an approximately 21x21 cm handsheet mold and mixed with addition of about 5000 g of water. The resulting slurry had the following weight percent of solid materials:

meta-aramid fibrids 6.5%;
para-aramid floc 43.5%;
particulate LCP 50%.

A wet-laid sheet was formed. The sheet was placed between two pieces of blotting paper, hand couched with a rolling pin, and dried in a hand sheet dryer at about 190°C.

A piece 7.1 x 7.1 cm was cut from the dried sheet, covered on both sides with an aluminum foil treated with a mold release Mono-Coat® 327W (sold by Chem-Trend Inc.) and placed in the platen press MTP-20 (sold by Tetrahedron Associates, Inc.) between two brass cover plates 1 mm thick each. The sheet was compressed in the press under the following conditions:

temperature 360°C, pressure 1.8 MPa for 2 min;
temperature 360°C, pressure 89 MPa for 5 min;

The press plates were then cooled with water while maintaining a constant pressure of 89 MPa. The final (compressed) sheet had a basis weight of 108.8 g/m$^2$, thickness of 81.3 $\mu$m and an apparent density 1.34 g/cm$^3$. With a calculated density of about 1.52 g/cm$^3$, the sheet was about 88% of the calculated "solid" density.

Example 2

The final sheet (laminate) from Example 1 was placed between two sheets of copper foil (20 $\mu$m thick) and a metal-clad laminate was prepared by hot compression in the same press and using the same compression cycle as described in Example 1. The polymer portion (without copper foil) in the final metal-clad laminate had thickness 78.7 $\mu$m and an apparent density of 1.38 g/cm$^3$, which was about 91% of the calculated "solid" density.

Example 3

Strand cut pellets of LCP were refined on a 30.5 cm diameter Sprout-Waldron type C-2976-A single rotating disc refiner equipped with plates in one pass with the gap between plates of about 25 $\mu$m, a feed speed of about 60 g/min. and continuous addition of water in quantity of about 4 kg of water per 1 kg of the pellets. The resulting LCP pulp was additionally refined in a Bantam® Micropulverizer, Model CF, to pass through a 30 mesh screen. A water slurry was prepared by mixing LCP pulp and poly(p-phenylene terephthalamide) floc. The slurry had the following percentages (as a percent of total solids) of solid materials:

LCP pulp 65%;
poly(p-phenylene terephthalamide) floc 35%.

A continuous sheet was formed from the slurry on a Rotonier (combination of Rotoformer and Fourdrinier) papermaking machine equipped with a horizontal thru-air drier. The headbox consistency was about 0.01%, forming speed about 5 m/min and temperature of air in the drying section of about 338°C. The formed paper was calendered at ambient temperature between two metal rolls 86 cm diameter each at a speed of about 7 m/min. and linear pressure of about 6500 N/cm.

Calendered material had basis weight of about 72.5 g/m$^2$ and apparent density of about 0.82 g/cm$^3$, which corresponded to about 57 % from calculated density. Tensile modulus in the machine direction was 2.52 GPa and in the transverse direction 1.65 GPa. Ten plies of calendered sheet (51 x 51 cm each) were placed between two sheets of 17 $\mu$m thick copper foil and compressed in a platen press at the following conditions: 348°C - 2.6 MPa - 1 min >> 348°C - 34 kPa - 1 min >> 348°C - 2.6 MPa - 1 min >> 149°C - 2.6 MPa - 1 min. The thickness of the final copper clad laminate was 0.541 mm, which corresponded to 0.507 mm thickness of polymeric material (the rest was the copper foil). Based on basis weight of 10 plies of calendered material loaded in the press (725 g/m$^2$) and thickness of polymer material in the final laminate (0.507 mm), apparent density of polymer material in the final copper clad laminate was estimated to be 1.43 g/cm$^3$, which corresponded to about 99% of the calculated density. After etching of copper foil, CTE in plane was determined as being in the range of +/- 1 PPm/°C .

### Example 4

Strand cut pellets of LCP were refined on 30.5 cm diameter Sprout-Waldron type C-2976-A single rotating disc refiner equipped with plates in one pass using a gap between plates of 25 $\mu$m, feeding speed of about 60 g/min. and continuous addition of water in quantity of about 4 kg of water per 1 kg of the pellets. This LCP pulp was additionally refined in a Bantam® Micropulverizer, Model CF, to pass through a 60 mesh screen. The slurry was prepared by mixing the LCP pulp with poly(p-phenylene terephthalamide) floc. The resulting slurry had the following percentages (as a percent of total solids) of solid materials:

LCP pulp 90%;
poly(p-phenylene terephthalamide) floc 10%.

A continuous sheet was formed from the slurry on a Rotonier (combination of Rotoformer and Fourdrinier) papermaking machine equipped with horizontal thru-air drier.

The headbox consistency was about 0.01%, forming speed about 5 m/min and temperature of air in the drying section of about 338 C. The formed material was calendered at ambient temperature between two metal rolls 4 cm diameter each at speed about 5 m/min. and linear pressure of about 2000 N/cm. Calendered material had a basis weight of 66.1 g/m$^2$ and apparent density about 0.66 g/ml which corresponded to about 46% of the calculated density. Its tensile modulus in the machine direction as 1.30 GPa, and about 0.93 GPa in the transverse direction. Ten plies of calendered sheet were placed between two sheets of 17 $\mu$m thick copper foil and compressed in the platen press under the following conditions: 348°C - 0.87 MPa - 1 min >> 348°C - 34 kPa - 1 min >> 348°C - 0.87 MPa - 1 min. >> 149°C - 0.87 MPa - 1 min. Density of polymeric material in the final copper clad laminate was 1.39 g/cm$^3$, which corresponded to about 96.5% of the calculated density. The CTE 23 ppm/°C in the machine direction and 33 ppm/°C in the transverse direction. Moisture absorption was 0.4 wt. %.

### Example 4

Sheets (25 cm x 21 cm) of THERMOUNT® reinforcement type 2N710 available from I.E. DuPont de Nemours & Co., Wilmington, DE, U.S.A., which is an aramid paper containing a majority of PPTA floc with some poly(m-phenylene isophthalamide fibrids) were impregnated in two steps with a water dispersion of Teflon® PFA [a thermoplastic copolymer of tetrafluoroethylene and perfluoro(propyl vinyl ether) available from E. I. DuPont de Nemours & Co., Wilmington, DE, U.S.A]. Each impregnation was conducted in a bath having about 60% solids, followed by squeezing between two glass rods and drying in an oven at 105°C. PFA content in the final impregnated sheets was about 77 wt. %. Impregnated sheets were consolidated by compression in 2 plies in a platen press under the following conditions: 316°C - 3.9 MPa - 5 min. >> 149°C - 3.9 MPa - 1 min. Consolidated sheets had basis weight 80.9 g/m$^2$, thickness 0.145 mm and apparent density 1.82 g/cm$^2$, which corresponded to 91% of the calculated density. Three consolidated sheets were compressed together between two sheets of copper foil 17 $\mu$m thick each at the following conditions: 316°C - 3.9 MPa - 10 min >> 149°C - 3.9 MPa - 1 min. In the final copper clad laminate, apparent density of polymeric material was about 1.88 g/cm$^2$, which corresponded to 94% of the calculated density. Moisture absorption of this material at 85°C and 85% relative humidity was 0.7 wt. %.

Example 5

One g of polybenzoxazole (PBO) fiber was placed in a laboratory mixer (British pulp evaluation apparatus) with 2500 g of water and agitated for 3 min. Independently, 69.77 g of an aqueous, never-dried, poly(m-phenylene isophthalamide) fibrid slurry (0.43% consistency and freeness 330 ml of Shopper-Riegler) was placed in the same type of laboratory mixer together with 1.70 g of LCP pulp (passed through a 30 mesh screen after grinding in a Bantam Micropulverizer)) and about 2000 g of water and agitated for 1 min. Both dispersions were poured together into an approximately 21x21 cm handsheet mold and mixed with addition of about 5000 g of water. The resulting slurry had the following percentages (of total solids) of solid materials:

poly(m-phenylene isophthalamide) fibrids 10%;
PBO floc 33%;
LCP pulp 57%

A wet-laid sheet was formed. The sheet was placed between two pieces of blotting paper, hand couched with a rolling pin, and dried in a hand sheet dryer at about 190°C. The dried sheet had basis weight of about 68.8 g/m$^2$. The dried sheet was consolidated by calendering at ambient temperature between two metal rolls 10 cm diameter each at a linear pressure of about 2000 N/cm and speed about 5 m/min. The calendered sheet had density of about 0.69 g/cm$^3$, which corresponded to about 48 % of the calculated density. The sheet was placed between two sheets of 17 $\mu$m thick copper foil and compressed in a platen press at the following cycle: 343°C - 0.21 MPa - 1 min >> 343° C - 33.1 MPa - 2 min >> 93°C - 33.1 MPa - 1 min. Polymeric material in the final copper clad laminate had apparent density of about 1.34 g/cm$^3$, which corresponded to about 93 % of the calculated density.

Example 6

Poly(p-phenylene terephthalamide) fiber (0.84 g) was placed in a laboratory mixer (British pulp evaluation apparatus) with 2500 g of water and agitated for 3 min. Independently, 65.12 g of an aqueous, never-dried, poly(m-phenylene isophthalamide) fibrid slurry (0.43% consistency and freeness 330 ml of Shopper-Riegler) was placed in the same type of laboratory mixer together with 1.68 g of PET floc and about 2000 g of water and agitated for 1 min. Both dispersions were poured together into an approximately 21x21 cm handsheet mold and mixed with addition of about 5000 g of water. The resulting slurry had the following percentages (of total solids) of solid materials:

poly(m-phenylene isophthalamide) fibrids 10%;
poly(p-phenylene terephthalamide) floc 30%;
poly(ethylene terephthalate) floc 60%

A wet-laid sheet was formed. The sheet was placed between two pieces of blotting paper, hand couched with a rolling pin, and dried in a hand sheet dryer at about 190°C. The dried sheet had basis weight of about 67.0 g/m$^2$. Another sheet was prepared by exactly the same procedure. Both sheets were placed together between two sheets of aluminum foil with mold release on their surfaces (see example 1) and compressed in the platen press at the following cycle: 266°C - 0.21 MPa - 2 min >> 266° C - 15.9 MPa - 2 min >> 93°C - 15.9 MPa - 2 min. The consolidated sheet had an apparent density of about 1.28 g/cm$^3$, which corresponded to about 91% of the calculated density.

Comparative Example A

Aramid paper with basis weight of 31 g/m$^2$ and a density of 0.64 g/ml made from 87% by weight PPTA floc (2.25 denier per filament, 6.7 mm cut length) and 13% by weight poly(m-phenylene isophthalamide) fibrids was prepreged with commercial multi-functional epoxy system L-1070 as in Example 2. Thirty-two prepregs made by the above process were further laminated between two Cu sheets (17 $\mu$m thick) under the following conditions in a vacuum press:

(a) Held for 1 h in vacuum (no external pressure or temperature).
(b) Heated to 200°C (5°C/min) from ambient temperature under a pressure of 6.9 MPa.
(c) Held for 1 h at 200°C and 6.9 MPa.
(d) Cooled to room temperature fast (water quench on platens) under pressure

Epoxy resin content in the polymer portion of the final laminate was about 53% wt. %. After etching of copper foil, properties of polymer portion of the laminate were measured. CTE e was about 14.2 ppm/°C in the machine direction and 12.1 ppm/°C in the transverse direction, and moisture absorption at 85°C and 85% humidity was about 2.1 wt. %.

**Claims**

1. A sheet, comprising:

    (a) a nonwoven fabric of short high tensile modulus fibers having a tensile modulus of 10 GPa or more when measured in accordance with ASTM D885-85 method, using a 1.1 twist multiplier; and
    (b) a liquid crystalline polymer having a low moisture absorption which absorbs less than 1.0 weight percent moisture, based on the weight of the thermoplastic polymer, when measured on a sheet of pure thermoplastic polymer as indicated in the description, in the section entitled "Procedure for Determining Equilibrium Moisture Absorption at 85°C and 85% relative humidity";

    said sheet having an apparent density which is at least 75% of its calculated density.

2. The sheet as recited in claim 1 wherein said apparent density is at least 90% of its calculated density.

3. The sheet as recited in claim 2 wherein at least some of said high tensile modulus fiber is coated or encapsulated by said liquid crystalline polymer.

4. The sheet as recited in claim 1 wherein said high tensile modulus fibers are an aramid.

5. The sheet as recited in claim 2 wherein said high tensile modulus fibers are an aramid.

6. The sheet as recited in claim 1 wherein a tensile modulus of said sheet and a thermal coefficient of expansion of said sheet, in a machine direction of said sheet is within 20% of a tensile modulus of said sheet and a thermal coefficient of expansion of said sheet, respectively, in a transverse direction of said sheet.

7. A circuit board comprising the sheet of claim 1.

8. A laminate comprising:

    (a) a sheet, comprising:

        (i) a nonwoven fabric of short high tensile modulus fibers having a tensile modulus of 10 GPa or more when measured in accordance with ASTM D885-85 method, using a 1.1 bwist multiplier; and
        (ii) a thermoplastic polymer having a low moisture absorption which absorbs less than 1.0 weight percent moisture, based on the weight of the thermoplastic polymer, when measured on a sheet of pure thermoplastic polymer as indicated in the description, in the section entitled "Procedure For Determining Equilibrium Moisture Absorption at 85°C and 85% relative humidity";

    provided that said sheet has an apparent density which is at least 75% of its calculated density; and
    (b) at least one metal layer contacting one surface of said sheets.

9. The laminate as recited in claim 8 wherein said apparent density is at least 90% of said calculated density.

10. The laminate of claim 8 or 9 wherein said thermoplastic polymer is a liquid crystalline polymer or a perfluoropolymer.

11. The laminate of claim 8, 9 or 10 wherein said high tensile modules fiber is an aramid.

12. A circuit board comprising the laminate of any one of claims 8 through 11.

13. A process for the production of a solid first sheet material, comprising the step of heating and applying pressure to:

    (a) a multilayer sheet structure, comprising, at least one layer containing a nonwoven fabric of short high tensile modulus fibers of a synthetic organic material having a tensile modulus of 10 GPa or more when measured in accordance with ASTM D885-85 method, using a 1.1 twist multiplier, and at least one other layer that comprises a thermoplastic polymer having a low moisture absorption which absorbs less than 1.0 weight percent moisture, based on the weight of the thermoplastic polymer, when measured on a sheet of pure thermoplastic polymer as indicated in the description, in the section entitled "Procedure for Determining Equilibrium Moisture Absorption at 85°C and 85% relative humidity";

to form a first sheet having an apparent density of at least 75% of its calculated density.

14. The process as recited in claim 13 wherein said apparent density is at least 90% of said calculated density.

15. The process as recited in claim 13 or 14 wherein said thermoplastic polymer is a liquid crystalline polymer or a perfluoropolymer.

16. The process as recited in claim 13, 14 or 15 wherein said high tensile modulus fiber is an aramid.

17. A circuit board produced from the sheet obtained by the process of claim 13, 14, 15 or 16.

18. A process for the production of a solid first sheet material, comprising the step of heating and applying pressure to:

(a) at least one second sheet comprising a nonwoven fabric of short high tensile modulus fibers having a tensile modulus of 10 GPa or more when measured in accordance with ASTM D885-85 method, using a 1.1 twist multiplier and a thermoplastic polymer having a low moisture absorptionwhich absorbs less than 1.0 weight percent moisture, based on the weight of the thermoplastic polymer, when measured on a sheet of pure thermoplastic polymer as indicated in the description, in the section entitled "Procedure for Determining Equilibrium Moisture Absorption at 85°C and 85% relative humidity",
or
at least one third sheet comprising nonwoven fabric of a short high tensile modulus fiber having a tensile modulus of 10 GPa or more when measured in accordance with ASTM D885-85 method, using a 1.1 twist multiplier and at least one fourth sheet comprising a thermoplastic polymer; and
(b) at least one metal sheet
to form a solid first sheet having an apparent density of at least 75% of its calculated density.

19. The process as recited in claim 18 wherein said apparent density is at least 90% of said calculated density.

20. The process as recited in claim 18 or 19 wherein said thermoplastic polymer is a liquid crystalline polymer or a perfluoropolymer.

21. The process as recited in claim 18, 19 or 20 wherein said high tensile modulus fiber is an aramid.

22. A circuit board produced from the sheet obtained by the process of claim 18, 19, 20 or 21.

**Patentansprüche**

1. Platte umfassend:

(a) einen Vliesstoff aus kurzen Fasern von hohem Zugmodul, die einen Zugmodul von 10 GPa oder mehr, wenn er der ASTM D885-85-Methode entsprechend unter Anwendung eines Drehungskoeffizienten von 1,1 gemessen wird, aufweisen und
(b) ein flüssigkristallines Polymer, das eine geringe Feuchtigkeitsabsorption aufweist und weniger als 1,0 Gewichtsprozent Feuchtigkeit, auf das Gewicht des thermoplastischen Polymers bezogen, absorbiert, wenn an einer Platte von reinem thermoplastischem Polymer gemessen, wie in der Beschreibung im Abschnitt mit dem Titel "Verfahren zum Bestimmen der Äquilibriumfeuchtigkeitsabsorption bei 85 °C und 85 % relativer Feuchte" angegeben,

wobei die Platte eine Schüttdichte aufweist, die mindestens 75 % ihrer berechneten Dichte beträgt.

2. Platte wie in Anspruch 1 angegeben, wobei die Schüttdichte mindestens 90 % ihrer berechneten Dichte beträgt.

3. Platte wie in Anspruch 2 angegeben, wobei mindestens ein Teil der Faser von hohem Zugmodul durch das flüssigkristalline Polymer beschichtet oder darin eingebettet wird.

**4.** Platte wie in Anspruch 1 angegeben, wobei die Fasern von hohem Zugmodul ein Aramid sind.

**5.** Platte wie in Anspruch 2 angegeben, wobei die Fasern von hohem Zugmodul ein Aramid sind.

**6.** Platte wie in Anspruch 1 angegeben, wobei ein Zugmodul der Platte und ein Wärmedehnungskoeffizient der Platte in Maschinenrichtung der Platte innerhalb von 20 % eines Zugmoduls der Platte bzw. eines Wärmedehnungskoffizienten der Platte in Querrichtung der Platte liegt.

**7.** Leiterplatte umfassend die Platte nach Anspruch 1.

**8.** Laminat umfassend:

(a) eine Platte umfassend:

(i) einen Vliesstoff aus kurzen Fasern von hohem Zugmodul, die einen Zugmodul von 10 GPa oder mehr, wenn er der ASTM D885-85-Methode entsprechend unter Anwendung eines Drehungskoeffizienten von 1,1 gemessen wird, aufweisen und
(ii) ein thermoplastisches Polymer, das eine geringe Feuchtigkeitsabsorption aufweist und weniger als 1,0 Gewichtsprozent Feuchtigkeit, auf das Gewicht des thermoplastischen Polymers bezogen, absorbiert, wenn an einer Platte von reinem thermoplastischem Polymer gemessen, wie in der Beschreibung im Abschnitt mit dem Titel "Verfahren zum Bestimmen der Äquilibriumfeuchtigkeitsabsorption bei 85 °C und 85 % relativer Feuchte" angegeben,
vorausgesetzt, dass die Platte eine Schüttdichte aufweist, die mindestens 75 % ihrer berechneten Dichte beträgt; und

(b) mindestens eine Metallschicht, die eine Oberfläche der Platten kontaktiert.

**9.** Laminat wie in Anspruch 8 angegeben, wobei die Schüttdichte mindestens 90 % der berechneten Dichte beträgt.

**10.** Laminat nach Anspruch 8 oder 9, wobei das thermoplastische Polymer ein flüssigkristallines Polymer oder ein Perfluorpolymer ist.

**11.** Laminat nach Anspruch 8, 9 oder 10, wobei die Faser von hohem Zugmodul ein Aramid ist.

**12.** Leiterplatte umfassend das Laminat nach einem der Ansprüche 8 bis 11.

**13.** Verfahren für die Herstellung eines festen Materials einer ersten Platte, umfassend den Schritt des Erhitzens und Aufbringens von Druck auf:

(a) ein mehrschichtiges Plattengebilde umfassend mindestens eine Schicht, die einen Vliesstoff aus kurzen Fasern von hohem Zugmodul aus einem synthetischen organischen Material, das einen Zugmodul von 10 GPa oder mehr, wenn er der ASTM D885-85-Methode entsprechend unter Anwendung eines Drehungskoeffizienten von 1,1 gemessen wird, aufweist, und mindestens eine andere Schicht enthält, die ein thermoplastisches Polymer umfasst, das eine geringe Feuchtigkeitsabsorption aufweist und weniger als 1,0 Gewichtsprozent Feuchtigkeit, auf das Gewicht des thermoplastischen Polymers bezogen, absorbiert, wenn an einer Platte von reinem thermoplastischem Polymer gemessen, wie in der Beschreibung im Abschnitt mit dem Titel "Verfahren zum Bestimmen der Äquilibriumfeuchtigkeitsabsorption bei 85 °C und 85 % relativer Feuchte" angegeben,
unter Bildung einer ersten Platte, die eine Schüttdichte von mindestens 75 % ihrer berechneten Dichte aufweist.

**14.** Verfahren wie in Anspruch 13 angegeben, wobei die Schüttdichte mindestens 90 % der berechneten Dichte beträgt.

**15.** Verfahren wie in Anspruch 13 oder 14 angegeben, wobei das thermoplastische Polymer ein flüssigkristallines Polymer oder ein Perfluorpolymer ist.

**16.** Verfahren wie in Anspruch 13, 14 oder 15 angegeben, wobei die Faser von hohem Zugmodul ein Aramid ist.

**17.** Leiterplatte hergestellt aus der Platte, die durch das Verfahren nach Anspruch 13, 14, 15 oder 16 erhalten wird.

**18.** Verfahren für die Herstellung eines festen Materials einer ersten Platte, umfassend den Schritt des Erhitzens und Aufbringens von Druck auf:

(a) mindestens eine zweite Platte umfassend einen Vliesstoff aus kurzen Fasern von hohem Zugmodul, die einen Zugmodul von 10 GPa oder mehr, wenn er der ASTM D885-85-Methode entsprechend unter Anwendung eines Drehungskoeffizienten von 1,1 gemessen wird, aufweisen und ein thermoplastisches Polymer, das eine geringe Feuchtigkeitsabsorption aufweist und weniger als 1,0 Gewichtsprozent Feuchtigkeit, auf das Gewicht des thermoplastischen Polymers bezogen, absorbiert, wenn an einer Platte von reinem thermoplastischem Polymer gemessen, wie in der Beschreibung im Abschnitt mit dem Titel "Verfahren zum Bestimmen der Äquilibriumfeuchtigkeitsabsorption bei 85 °C und 85 % relativer Feuchte" angegeben,
oder
mindestens eine dritte Platte umfassend einen Vliesstoff aus kurzer Faser von hohem Zugmodul, die einen Zugmodul von 10 GPa oder mehr, wenn er der ASTM D885-85-Methode entsprechend unter Anwendung eines Drehungskoeffizienten von 1,1 gemessen wird, aufweist und mindestens eine vierte Platte umfassend ein thermoplastisches Polymer; und
(b) mindestens eine Metallplatte
unter Bildung einer festen ersten Platte, die eine Schüttdichte von mindestens 75 % ihrer berechneten Dichte aufweist.

**19.** Verfahren wie in Anspruch 18 angegeben, wobei die Schüttdichte mindestens 90 % ihrer berechneten Dichte beträgt.

**20.** Verfahren wie in Anspruch 18 oder 19 angegeben, wobei das thermoplastische Polymer ein flüssigkristallines Polymer oder ein Perfluorpolymer ist.

**21.** Verfahren wie in Anspruch 18, 19 oder 20 angegeben, wobei die Faser von hohem Zugmodul ein Aramid ist.

**22.** Leiterplatte, die aus der Platte hergestellt ist, das durch das Verfahren nach Anspruch 18, 19, 20 oder 21 erhalten wird.

**Revendications**

**1.** Feuille, comprenant:

(a) un tissu non tissé de fibres courtes à haut module de traction, ayant un module de traction de 10 GPa ou plus lorsqu'il est mesuré conformément à la méthode ASTM D885-85, en utilisant un multiplicateur de torsion de 1,1; et
(b) un polymère cristallin liquide possédant une basse absorption d'humidité, qui absorbe moins de 1,0 pour cent en poids d'humidité, sur la base du poids du polymère thermoplastique, lorsqu'elle est mesurée sur une feuille de polymère thermoplastique pur comme il est indiqué dans la description, dans la section intitulée « Procédure pour déterminer l'absorption d'humidité à l'équilibre à 85°C et 85% d'humidité relative »;

ladite feuille possédant une densité apparente qui est d'au moins 75% de sa densité calculée.

**2.** Feuille selon la revendication 1, dans laquelle ladite densité apparente est d'au moins 90% de sa densité calculée.

**3.** Feuille selon la revendication 2, dans laquelle au moins une partie de ladite fibre à haut module de traction est revêtue ou encapsulée par ledit polymère cristallin liquide.

**4.** Feuille selon la revendication 1, dans laquelle lesdites fibres à haut module de traction sont un aramide.

**5.** Feuille selon la revendication 2, dans laquelle lesdites fibres à haut module de traction sont un aramide.

**6.** Feuille selon la revendication 1, dans laquelle le module de traction de ladite feuille et le coefficient de dilatation thermique de ladite feuille, dans une direction machine de ladite feuille, est dans les 20% du module de traction de ladite feuille et du coefficient de dilatation thermique de ladite feuille, respectivement, dans une direction transversale de ladite feuille.

**7.** Carte de circuits comprenant la feuille selon la revendication 1.

**8.** Stratifié comprenant:

(a) une feuille, comprenant:

(i) un tissu non tissé de fibres courtes à haut module de traction, ayant un module de traction de 10 GPa ou plus lorsqu'il est mesuré conformément à la méthode ASTM D885-85, en utilisant un multiplicateur de torsion de 1,1; et
(ii) un polymère thermoplastique possédant une basse absorption d'humidité, qui absorbe moins de 1,0 pour cent en poids d'humidité, sur la base du poids du polymère thermoplastique, lorsqu'elle est mesurée sur une feuille de polymère thermoplastique pur comme il est indiqué dans la description, dans la section intitulée « Procédure pour déterminer l'absorption d'humidité à l'équilibre à 85°C et 85% d'humidité relative »;
à condition que ladite feuille possède une densité apparente qui est d'au moins 75% de sa densité calculée; et

(b) au moins une couche de métal en contact avec une surface desdites feuilles.

**9.** Stratifié selon la revendication 8, dans lequel ladite densité apparente est d'au moins 90% de ladite densité calculée.

**10.** Stratifié selon la revendication 8 ou 9, dans lequel ledit polymère thermoplastique est un polymère cristallin liquide ou un perfluoropolymère.

**11.** Stratifié selon la revendication 8, 9 ou 10, dans lequel ladite fibre à haut module de traction est un aramide.

**12.** Carte de circuits comprenant le stratifié selon l'une quelconque des revendications 8 à 11.

**13.** Procédé pour la production d'un matériau de première feuille solide, comprenant l'étape de chauffage et d'application d'une pression sur:

(a) une structure en feuilles multicouche, comprenant au moins une couche contenant un tissu non tissé de fibres courtes à haut module de traction d'un matériau organique synthétique, ayant un module de traction de 10 GPa ou plus lorsqu'il est mesuré conformément à la méthode ASTM D885-85, en utilisant un multiplicateur de torsion de 1,1, et au moins une autre couche qui comprend un polymère thermoplastique possédant une basse absorption d'humidité, qui absorbe moins de 1,0 pour cent en poids d'humidité, sur la base du poids du polymère thermoplastique, lorsqu'elle est mesurée sur une feuille de polymère thermoplastique pur comme il est indiqué dans la description, dans la section intitulée « Procédure pour déterminer l'absorption d'humidité à l'équilibre à 85°C et 85% d'humidité relative »;
pour former une première feuille possédant une densité apparente d'au moins 75% de sa densité calculée.

**14.** Procédé selon la revendication 13, dans lequel ladite densité apparente est d'au moins 90% de ladite densité calculée.

**15.** Procédé selon la revendication 13 ou 14, dans lequel ledit polymère thermoplastique est un polymère cristallin liquide ou un perfluoropolymère.

**16.** Procédé selon la revendication 13, 14 ou 15, dans lequel ladite fibre à haut module de traction est un aramide.

**17.** Carte de circuits produite à partir de la feuille obtenue par le procédé selon la revendication 13, 14, 15 ou 16.

**18.** Procédé pour la production d'un matériau de première feuille solide, comprenant l'étape de chauffage et d'application d'une pression sur:

(a) au moins une deuxième feuille comprenant un tissu non tissé de fibres courtes à haut module de traction, ayant un module de traction de 10 GPa ou plus lorsqu'il est mesuré conformément à la méthode ASTM D885-85, en utilisant un multiplicateur de torsion de 1,1, et un polymère thermoplastique possédant une basse absorption d'humidité, qui absorbe moins de 1,0 pour cent en poids d'humidité, sur la base du poids du polymère thermoplastique, lorsqu'elle est mesurée sur une feuille de polymère thermoplastique pur comme il est indiqué dans la description, dans la section intitulée « Procédure pour déterminer l'absorption d'humidité à l'équilibre à 85°C et 85% d'humidité relative »;
ou

au moins une troisième feuille comprenant un tissu non tissé de fibres courtes à haut module de traction, ayant un module de traction de 10 GPa ou plus lorsqu'il est mesuré conformément à la méthode ASTM D885-85, en utilisant un multiplicateur de torsion de 1,1, et au moins une quatrième feuille comprenant un polymère thermoplastique; et

(b) au moins une feuille de métal

pour former une première feuille solide possédant une densité apparente d'au moins 75% de sa densité calculée.

19. Procédé selon la revendication 18, dans lequel ladite densité apparente est d'au moins 90% de ladite densité calculée.

20. Procédé selon la revendication 18 ou 19, dans lequel ledit polymère thermoplastique est un polymère cristallin liquide ou un perfluoropolymère.

21. Procédé selon la revendication 18, 19 ou 20, dans lequel ladite fibre à haut module de traction est un aramide.

22. Carte de circuits produite à partir de la feuille obtenue par le procédé selon la revendication 18, 19, 20 ou 21.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000334871 A
- JP 11117184 A
- WO 921089 A
- JP 11229290 A
- US 4118372 A
- US 4886578 A
- US 3756908 A
- US 3620903 A
- US 5965072 A
- US 5998309 A
- US 3991013 A
- US 3991014 A
- US 4011199 A
- US 4048148 A
- US 4075262 A
- US 4083829 A
- US 4122070 A
- US 4130545 A
- US 4153779 A
- US 4159365 A
- US 4161470 A
- US 4169933 A
- US 4184996 A
- US 4189549 A
- US 4219461 A
- US 4232143 A
- US 4232144 A
- US 4245082 A
- US 4256624 A
- US 4269965 A
- US 4272625 A
- US 4370466 A
- US 4383105 A
- US 4447592 A
- US 4522974 A
- US 4617369 A
- US 4664972 A
- US 4684712 A
- US 4727129 A
- US 4727131 A
- US 4728714 A
- US 4749769 A
- US 4762907 A
- US 4778927 A
- US 4816555 A
- US 4849499 A
- US 4851496 A
- US 4851497 A
- US 4857626 A
- US 4864013 A
- US 4868278 A
- US 4882410 A
- US 4923947 A
- US 4999416 A
- US 5015721 A
- US 5015722 A
- US 5025082 A
- US 5086158 A
- US 5102935 A
- US 5110896 A
- US 5143956 A
- US 5710237 A
- EP 356226 A
- US 5202184 A
- US 4698267 A
- US 4729921 A
- US 3767756 A
- US 3869430 A
- US 5223094 A
- US 5314742 A
- US 5209819 A
- EP 214827 A
- WO 9939021 A

**Non-patent literature cited in the description**

- **M. W. JAWITZ.** Printed Circuit Board Materials Handbook. McGraw-Hill Book Co, 1997
- **K. FELDMANN et al.** *Metalloberflaeche,* 1997, vol. 51, 349-352